# FASCICULE DE BREVET EUROPEEN

(11) **EP 3 402 909 B1**
(45) Date de publication et mention de la délivrance du brevet: **10.08.2022**
(21) Numéro de dépôt: 17703036.8
(22) Date de dépôt: 16.01.2017
(51) Int. Cl.: C23C 16/27, C23C 16/30, C23C 16/48, C30B 15/26, C30B 29/22

(54) **MÉTHODE POUR SYNTHÉTISER UNE MATIÈRE.**
VERFAHREN ZUR SYNTHESE EINES MATERIALS
METHOD FOR SYNTHESISING A MATERIAL

(30) Priorité: 15.01.2016 BE 201605032
(43) Date de publication de la demande: 21.11.2018
(73) Titulaire: Diarotech S.A., 6060 Gilly (BE)
(72) Inventeur: TELLEZ OLIVA, Horacio J., 6000 Charleroi (BE); ROCH, Alain, 7070 Le Roeulx (BE); LAMINE, Etienne, 1490 Court-Saint-Etienne (BE)
(74) Mandataire: Office Kirkpatrick
(86) Numéro de dépôt international: PCT/EP2017/050763
(87) Numéro de publication internationale: WO 2017/121892

(56) Documents cités:
- EP-B1- 2 526 220
- WO-A1-2012/013824
- US-A- 4 898 748
- BUHLER J ET AL: "Back-scattering CARS diagnostics on CVD diamond", DIAMOND AND RELATED MATERIALS, ELSEVIER SCIENCE PUBLISHERS, AMSTERDAM, NL, vol. 8, no. 2-5, 1 mars 1999 (1999-03-01), pages 673-676, XP004364968, ISSN: 0925-9635, DOI: 10.1016/S0925-9635(98)00414-2

## Description

### Domaine technique

Selon un premier aspect, la présente invention concerne une méthode pour synthétiser une matière, par exemple du diamant. Selon un deuxième aspect, la présente invention concerne un dispositif pour synthétiser une matière.

### Art antérieur

Le document WO2012/013824 A1 divulgue un procédé selon lequel un rayonnement électromagnétique est envoyé lors d'un dépôt chimique en phase vapeur (en abrégé CVD pour chemical vapour déposition) afin d'augmenter la vitesse de la croissance de la matière synthétisée. Le rayonnement électromagnétique a la forme d'un faisceau de photons dont les fréquences correspondent aux fréquences d'absorption (intrinsèques ou activées par défaut) et de diffusion inélastique (de photons et de neutrons) de la matière à synthétiser.

Il serait avantageux d'augmenter encore la vitesse de la croissance de la matière synthétisée. En outre, il serait avantageux d'améliorer la qualité de la matière synthétisée.

### Résumé de l'invention

Selon un premier aspect, un des buts de l'invention est de fournir une méthode qui permet d'adresser certains problèmes mentionnés plus haut. A cet effet, l'invention propose une méthode de synthèse d'une matière telle que revendiquée dans la revendication 1.

Le fait de diriger des photons Raman vers le substrat permet de les diriger vers une zone où la synthèse de matière se produit, et où, selon l'invention, il est voulu qu'une émission Raman stimulée se produise.

Les photons pompes permettent une excitation vers un état d'énergie excité et les photons Raman permettent de stimuler une émission Raman à partir d'un état d'énergie excité.

Les étapes de la méthode selon l'invention permettent ainsi de réunir les conditions pour un effet Raman. Cet effet Raman peut avoir plusieurs avantages.

Il peut permettre de déclencher ou d'activer la synthèse de la matière. Si d'autres réactions que la synthèse de la matière désirée sont possibles, il peut permettre de favoriser la synthèse de la matière désirée par rapport à ces autres réactions en minimisant le chemin énergétique réactionnel correspondant. Il peut aussi permettre d'améliorer la structure de la matière à synthétiser, par exemple en permettant une cristallisation d'une partie de la matière qui avait été initialement formée de manière amorphe lors de la synthèse.

Dans le cadre du présent document, un photon Raman est un photons apte à stimuler une émission Raman et/ou un photon émis par émission Raman, et peut être Stokes ou anti-Stokes. Lorsqu'ils sont envoyés vers de la matière afin de stimuler une émission Raman, les photons Raman sont des "photons de stimulation" ou "photons sondes". Lorsqu'ils sont émis par de la matière par émission Raman spontanée ou stimulée les photons Raman sont des "photons émis".

Dans le cadre du présent document, une émission Raman peut correspondre à un effet Raman linéaire, à un effet Raman non-linéaire ou à une combinaison, et impliquer de multiples transitions entre états énergétiques, qu'elles soient radiatives ou autres. Dans le cadre du présent document, un effet Raman peut être un effet Hyper-Raman.

Dans une réalisation de l'invention, les moyens pour diriger des photons Raman dans la chambre comprennent un dispositif permettant un changement de direction de photons Raman et l'étape 8) comprend un changement de direction de photons Raman. Cette réalisation de l'invention est particulièrement adaptée lorsque c'est la matière elle-même qui, suite à une précédente émission Raman spontanée ou stimulée, est une source de photons R aman.

Préférentiellement, le changement de direction de photons Raman est réalisé à l'aide d'une cavité optique. Une telle cavité est particulièrement apte à créer une amplification des émissions Raman.

Dans une réalisation de l'invention, les moyens pour diriger des photons Raman dans la chambre comprennent un dispositif de génération de photons Raman. Cette réalisation de l'invention est particulièrement adaptée lorsqu'un dispositif autre que la matière elle-même est une source de photons Raman.

Préférentiellement, le dispositif de génération de photons Raman est comprend une cavité optique et un élément apte à générer des photons Raman et le substrat est disposé en-dehors du dispositif de génération de photons Raman.

Avantageusement, les étapes 6), 7) et 8) sont simultanées.

Dans une réalisation de l'invention, la méthode comprend une étape de réflexion totale des photons pompes sur une surface proche des réactifs. Cette réflexion totale permet une forte densité de photons pompes à proximité d'une surface du substrat où se réalise la synthèse de matière. Cela a pour conséquence une grande quantité d'émissions Raman dans cette partie du substrat ce qui est particulièrement avantageux sur la partie du surface servant de point de départ à la synthèse.

Dans une réalisation de l'invention, des photons Raman ont une fréquence plus petite que la fréquence des photons pompes.

Dans une réalisation de l'invention, des photons Raman ont une fréquence plus grande que la fréquence des photons pompes.

De manière avantageuse, la méthode comprend en outre la création d'une paire électron-trou et un pompage de phonons.

De manière avantageuse, des états d'énergie intermédiaires sont présents entre la bande de valence et la bande de conduction et comprenant en outre que des photons pompes induisent des excitations entre deux de ces états d'énergie intermédiaires et que des émissions Raman anti-Stokes stimulées par des photons Raman induisent des désexcitations entre deux de ces états d'énergie intermédiaires.

Avec la méthode de l'invention, la matière à synthétiser peut par exemple être une matière solide, une matière solide monocristalline, une matière solide poly-cristalline, une matière solide amorphe, une matière solide synthétisable par CVD, une matière solide synthétisable par épitaxie, une matière solide ayant une structure cristalline de type diamant, une matière solide de même composition que du diamant mais étant au moins partiellement amorphe, du diamant, du silicium, un composé semi-conducteur dopé ou non, un alliage par exemple métallique. D'autres types de matière pourraient néanmoins être synthétisés avec la méthode de l'invention.

Selon un deuxième aspect, un des buts de l'invention est de fournir un dispositif qui permet d'adresser certains problèmes mentionnés plus haut. A cet effet, l'invention propose un dispositif pour synthétiser une matière, tel que revendiqué dans la revendication 8.

Les avantages mentionnés pour la méthode s'appliquent mutatis mutandis au dispositif.

Préférentiellement, les moyens pour diriger des photons Raman dans la chambre comprennent un dispositif permettant un changement de direction de photons Raman et apte à diriger des photons Raman vers le substrat.

De manière avantageuse, le dispositif agencé pour réaliser un changement de direction de photons Raman comprend deux miroirs disposés pour réfléchir vers un substrat porté par le porte-substrat des photons Raman provenant d'un substrat porté par le porte-substrat.

De façon préférentielle, au moins un des miroirs est un miroir dichroïque agencé pour laisser passer les photons pompes provenant du dispositif générateur de photons.

De manière avantageuse, le dispositif agencé pour réaliser un changement de direction de photons Raman comprend une cavité optique.

Préférentiellement le dispositif générateur de photons comprend un laser pulsé. Un laser pulsé est particulièrement approprié pour les photons pompes car il permet un flux de photons pompes particulièrement intense, qui donne lieu à des émissions Raman particulièrement nombreuses. En outre, l'utilisation d'un faisceau de photons pompes pulsé permet de rester hors équilibre et permet qu'il y a moins de diffusion dans la matière en formation.

Dans une réalisation de l'invention, la chambre est agencée pour pouvoir être mise sous vide et pouvoir contenir un plasma d'ions et comprenant en outre un dispositif de création de plasma apte à ioniser au moins une partie du gaz pour former un plasma à proximité d'un substrat porté par le porte-substrat.

### Brève description des figures

D'autres caractéristiques et avantages de l'invention apparaîtront à la lecture de la description détaillée qui suit pour la compréhension de laquelle on se reportera aux figures annexées parmi lesquelles :
- la figure 1 illustre une méthode, selon l'invention, servant à la synthèse d'une matière en utilisant des photons Raman,
- la figure 2a illustre des états d'énergie et les transitions impliqués par la méthode selon l'invention dans le cas d'une émission Raman Stokes spontanée,
- la figure 2b illustre des états d'énergie et les transitions impliqués par la méthode selon l'invention dans le cas d'une émission Raman Stokes stimulée,
- la figure 2c illustre des états d'énergie et les transitions impliqués par la méthode selon l'invention dans le cas d'une émission Raman anti-Stokes spontanée,
- la figure 2d illustre des états d'énergie et les transitions impliqués par la méthode selon l'invention dans le cas d'une émission Raman anti-Stokes stimulée,
- la figure 3 illustre de façon schématique la structure d'un dispositif de synthèse de matière par CVD selon une première réalisation de l'invention,
- la figure 4 illustre de façon schématique la structure d'un dispositif de synthèse de matière par le procédé de Czochralski ne faisant pas partie de la présente invention,
- la figure 5 schématise une disposition de certains éléments du dispositif dans une réalisation de l'invention où le substrat, les réactifs et la zone de synthèse se trouvent dans une cavité optique,
- la figure 6 illustre une variante de l'invention utilisant le phénomène de réflexion totale,
- la figure 7 schématise une disposition de certains éléments du dispositif dans une réalisation de l'invention où le substrat, les réactifs et la zone de synthèse se trouvent à l'extérieur d'un dispositif de génération de photons Raman,
- la figure 8 schématise une première utilisation d'une émission anti-Stokes pour réaliser un pompage de phonons, et
- la figure 9 schématise une deuxième utilisation d'une émission anti-Stokes pour réaliser un pompage de phonons.

### Modes de réalisation de l'invention

La présente invention est décrite avec des réalisations particulières et des références à des figures mais l'invention n'est pas limitée par celles-ci. Les dessins ou figures décrits ne sont que schématiques et ne sont pas limitants.

Dans le contexte du présent document, les termes « premier » et « deuxième » servent uniquement à différencier les différents éléments et n'impliquent pas d'ordre entre ces éléments.

Sur les figures, les éléments identiques ou analogues peuvent porter les mêmes références.

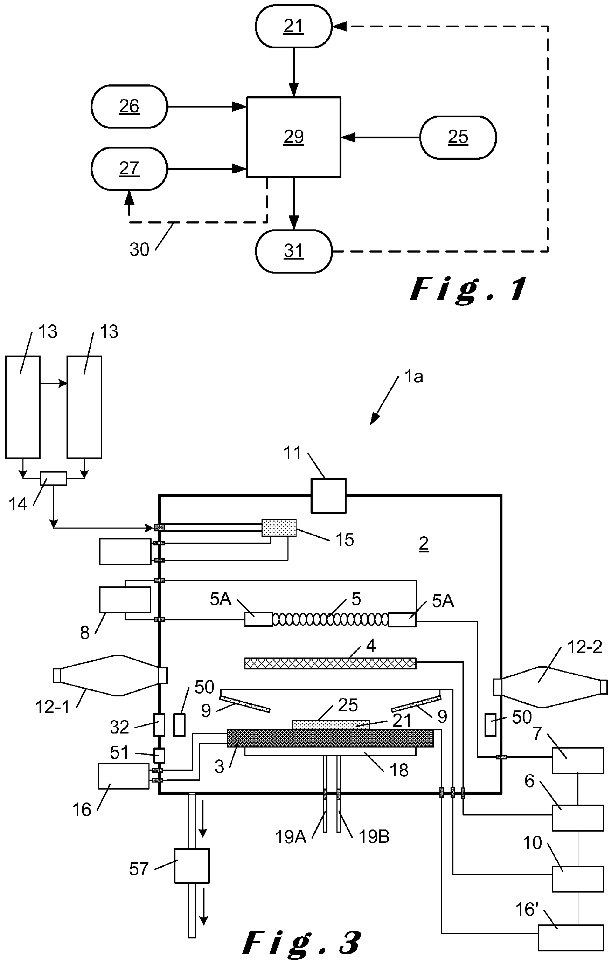

La figure 1 illustre une méthode 20 de synthèse d'une matière en utilisant des photons Raman.

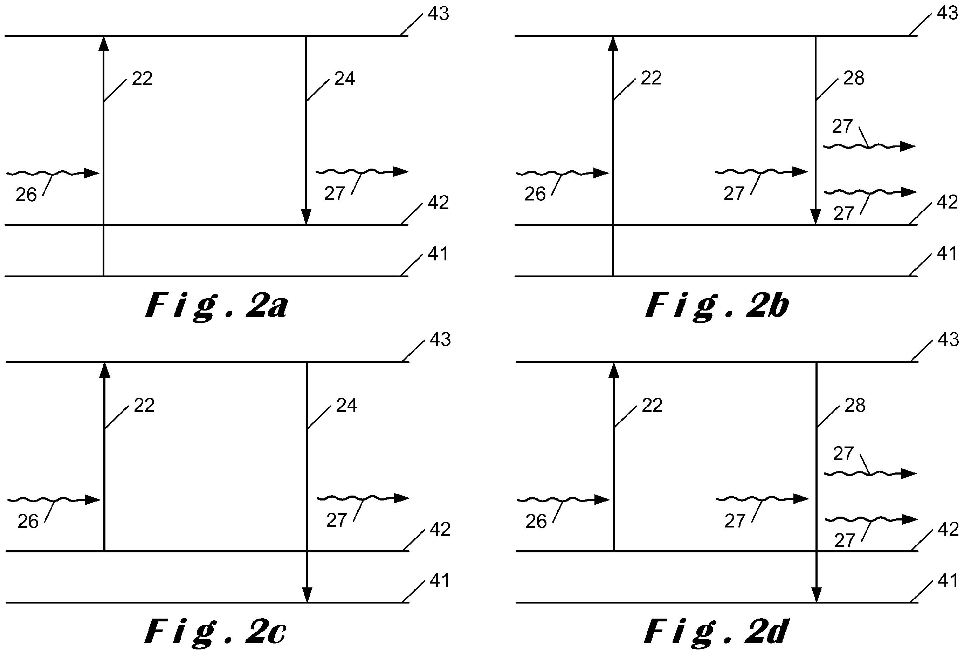

Les figures 2a à 2d illustrent des états d'énergie potentiellement impliqués lors de la méthode 20: un premier état 41, un deuxième état 42 et un troisième état 43. Le deuxième état 42 correspond à un niveau d'énergie plus haut que le premier état 41, et le troisième état 43 correspond à un niveau d'énergie plus haut que le deuxième état 42. Le premier état 41 peut être l'état fondamental, le deuxième état 42 peut être un état vibrationnellement excité et le troisième état 43 peut être un état excité plus haut que le deuxième état 42. Le troisième état 43 peut être un état d'énergie virtuel. Le troisième état 43 peut être un état de la bande de valence. Le troisième état 43 peut être un état créé par la présence d'une impureté ou d'un défaut cristallin.

La figure 2a illustre les transitions dans le cas d'une émission Raman Stokes spontanée, la figure 2b illustre les transitions dans le cas d'une émission Raman Stokes stimulée, la figure 2c illustre les transitions dans le cas d'une émission Raman anti-Stokes spontanée, la figure 2d illustre les transitions dans le cas d'une émission Raman anti-Stokes stimulée.

Revenant à la figure 1, un substrat 21 est mis en présence de réactifs 25 permettant la synthèse d'une matière 31 sur ce substrat 21.

Des photons 26 pompes sont envoyés de façon à créer une transition vers le troisième état d'énergie 43 (figure 2) dans la matière 31, par exemple par pompage optique. Les photons 26 pompes ont une énergie égale à la différence d'énergies entre le troisième état 43 et premier état 41 dans le cas de l'utilisation de photons Raman Stokes (figure 2b) et des photons pompes 26 ont une énergie égale à la différence d'énergies entre le troisième état 43 et le deuxième état 42 dans le cas de l'utilisation de photons Raman anti-Stokes (figure 2d).

Des photons Raman 27, ayant une fréquence telle qu'ils sont aptes à stimuler une émission Raman 28 stimulée dans la matière 31, sont aussi envoyés de façon à stimuler une émission Raman 28 stimulée dans la matière 31.

L'envoi des photons 26 pompes et des photons Raman 27 a préférentiellement lieu de façon simultanée avec la synthèse 29 de la matière. Dans une réalisation de l'invention, les photons 26 pompes et les photons Raman 27 sont envoyés après la synthèse 29 de la matière, ce qui permet de corriger des éventuels défauts dans une structure cristalline de la matière 31.

L'émission Raman 28 stimulée donne lieu à l'émission de photons Raman 27. L'émission Raman stimulée 28 génère, par photon 27 Raman reçu, deux photons Raman 27 dont l'énergie est égale à celle du photon 27 Raman reçu (figures 2b et 2d). Dans une réalisation de l'invention, ces photons Raman 27 émis sont redirigés 30 de façon à induire de nouvelles émissions Raman 28 stimulées.

Dans une réalisation de l'invention, les photons pompes 26 sont polarisés. En particulier, la disposition par rapport au substrat 21 d'un dispositif 32 générateur de photons envoyant les photons pompes 26 peut être choisie pour que la direction de polarisation et/ou la direction d'incidence des photons 26 pompes corresponde à une direction de gain Raman maximale, dans laquelle la probabilité d'engendrer une transition Raman est particulièrement grande. En outre, la disposition par rapport au substrat 21 de moyens pour diriger des photons Raman 27 dirige le substrat peut être choisie pour que la direction de polarisation et/ou la direction d'incidence des photons Raman 27 corresponde à une direction déterminée.

Dans une réalisation de l'invention, la synthèse 29 est en outre favorisée par une absorption de photons ayant une fréquence égale à une fréquence présente dans un des spectres électromagnétiques d'absorption et de diffusion inélastique de la matière à synthétiser, comme décrit dans le document WO2012/013824 A1. La matière synthétisée 31 à synthétiser peut être tant un matériau solide, qu'un liquide ou même un gaz.

Comme chaque photon 27 Raman utilisé lors de l'émission 28 Raman stimulée donne lieu à deux photons Raman 27 émis, si les photons Raman 27 émis sont redirigés 30 vers une zone de synthèse 29, il se produit un phénomène d'amplification du nombre de photons ayant une fréquence égale à la fréquence d'un photon émis par effet Raman et donc une amplification du nombre de transitions par émission Raman stimulée. Cela a pour conséquence une accélération de la synthèse 29 de la matière.

Le substrat 21 est préférentiellement cristallin ou poly-cristallin. Le substrat 21 et la matière synthétisée 31 peuvent être de même nature.

La méthode de synthèse selon l'invention permet notamment de synthétiser une matière solide, une matière solide monocristalline, une matière solide poly-cristalline, une matière solide amorphe, une matière solide synthétisable par CVD, une matière solide ayant une structure cristalline de type diamant, une matière solide de même composition que du diamant mais étant au moins partiellement amorphe, un diamant, un diamant comprenant des impuretés, du silicium, du PbWO4, du Ba(NO₃)₂, du KGd(WO₄)₂, du BaMoO₄, du SrMoO₄, du SrWO₄, du CaMoO₄, du CaWO₄, du TeO₂ ou du PbMoO₄.

Selon l'invention, la synthèse 29 est un dépôt par CVD et les réactifs 25 sont des ions d'un plasma créé à proximité d'une surface du substrat.

Dans des variantes selon l'invention, la synthèse 29 est un dépôt par CVD simple, par PECVD opérant avec un plasma continu, par PECVD opérant avec un plasma radiofréquence, par PECVD avec un plasma produit par micro-onde, par CVD opérant avec un plasma produit par combustion, par PECVD avec une torche à plasma.

La méthode de synthèse selon l'invention permet notamment de synthétiser une matière solide, une matière solide monocristalline, une matière solide poly-cristalline, une matière solide amorphe, une matière solide synthétisable par CVD, une matière solide ayant une structure cristalline de type diamant, une matière solide de même composition que du diamant mais étant au moins partiellement amorphe ou un diamant.

Selon un exemple d'utilisation de la méthode selon l'invention, le substrat 21 et la matière synthétisée 31 sont du diamant. Un gaz servant à former le plasma peut comprendre du CH₄ ou du C₂H₂, et du H₂, et les ions 25 du plasma peuvent comprendre du CH⁺₃. La fréquence des photons 26 pompes peut être choisie pour être apte à générer des vibrations C-H ou C-C de surface. Notamment, une longueur d'onde entre 3.3 et 3.5 um peut être utilisée pour les photons 26 pompes, de façon à exciter le mode transverse d'élongation de la liaison C-H. Des photons 26 pompes de cette longueur d'onde peuvent par exemple être obtenus par laser de type HeNe résonant à 3.39 um ou par un laser de puissance suivi d'un cristal opto.

La figure 3 illustre de façon schématique la structure d'un dispositif 1a pour mettre en œuvre la méthode selon la première réalisation de l'invention. Le dispositif 1a est agencé pour l'application d'un procédé pour synthétiser une matière par dépôt chimique en phase vapeur à filament chaud (HFCVD; Hot Filament Chemical Vapour Déposition). Il sera toutefois clair que le dispositif illustré permet également tout autre procédé pour synthétiser par dépôt chimique en phase vapeur (CVD) une matière et que l'invention n'est pas limitée au procédé HFCVD mais s'applique à tout procédé CVD.

Le dispositif 1a illustré à la figure 3 comporte une chambre 2 sous vide, qui de préférence est amenée à une pression de 10⁻³ Torr avant de démarrer le procédé de synthèse. La mise sous vide de la chambre est réalisée de façon connue par exemple à l'aide d'une pompe. Dans la chambre se trouve un porte-substrat 3, par exemple formé par un plateau, agencé à porter le substrat 21. Le substrat 21 peut être toute substance compatible pour la réalisation du dépôt, comme par exemple du diamant, W, WCCo, WCNi silice, etc.

Le porte-substrat est de préférence relié à une première source de tension 16 de courant alternatif pour des raisons qui seront décrites ultérieurement. Le cas échéant, le porte-substrat est également relié à une source de courant continue 16'. Le porte-substrat 3, est de préférence monté sur un plateau de refroidissement 18 servant à réguler la température du substrat. A cette fin, une entrée 19A et une sortie 19B de liquide de refroidissement sont reliées à ce plateau de refroidissement 18.

Au-dessus du substrat se trouve une grille 4 et au-dessus de la grille un filament 5. Le filament est de préférence monté entre deux collimateurs 5A, qui servent à focaliser le champ électrique pour une meilleure collimation du plasma. Les collimateurs permettent une meilleure distribution de la température, ainsi que du plasma dans la région du dépôt. Il faut noter également que l'invention n'est pas limitée à la position de la grille et du filament telle qu'illustrée à la figure 3, et que ces positions peuvent être inversées.

La grille 4 est reliée à une deuxième source de tension 6 et le filament 5 à une troisième source de tension 7. La deuxième et la troisième sources de tension sont des sources de tension à courant continu. La grille peut, le cas échéant, également être reliée à une quatrième source de tension de courant alternatif (non repris dans le dessin). Le filament est également relié à une cinquième source de tension 8 qui est une source de tension de courant alternatif. Les premières, deuxièmes et troisièmes sources de tension servent à faire varier le potentiel électrique entre le substrat, la grille et le filament, alors que la cinquième source de tension 8 sert au chauffage du filament. Par la variation du potentiel électrique entre le substrat, la grille et le filament, il est possible de faire varier le champ électrique dans la chambre et ainsi de contrôler le plasma qui sera produit dans la chambre. La tension appliquée sur le filament et la grille peut varier entre 0.1 et 400 Volt en fonction de la matière à synthétiser. La grille sert essentiellement à régler le flux des substances chimiques porteuses de radicaux ou des molécules insaturées présentes dans la chambre, alors que le filament sert à réaliser l'activation du gaz.

Le dispositif 1a suivant l'invention comporte également un système 9 de focalisation du plasma placé en périphérie du substrat et agencé pour améliorer la distribution de la température et du plasma dans la région où la synthèse de la matière solide aura lieu et où s'effectue le dépôt.

Le système 9 de focalisation du plasma est par exemple formé par un anneau placé autour du substrat et décalé vers le haut de la chambre par rapport au substrat. Le système de focalisation 9 peut également être formé par un jeu de fils en métal repliés sensiblement en forme de U inversé et placés autour du substrat. Le système de focalisation du plasma est alimenté par une sixième source de tension 10, qui fournit un courant continu. La forme d'anneau pour la focalisation du plasma en relation au filament est de préférence réalisée par deux demi-cercles placés de part et d'autre du porte-substrat. Le système 9 de focalisation du plasma est de préférence placé de façon inclinée vers le porte-substrat afin de mieux focaliser le plasma vers le substrat.

Le dispositif suivant l'invention comporte aussi préférentiellement au moins un générateur de faisceaux de photons 11 disposé au-dessus de la chambre et agencé pour produire des rayons énergétiques, en particulier des rayons Infra Rouge (IR), sous forme d'un faisceau de photons. Le nombre de générateurs de faisceaux de photons est déterminé par la cristallographie de la substance et n'est donc pas limité à celui repris dans la figure 3. Ce ou ces générateurs servent à produire des rayons énergétiques dont la fréquence est déterminée par la fonction de densité spectrale Ψ(ω, K) de la matière à synthétiser, où w représente la fréquence et K le vecteur d'onde qui est polarisé ou non dans un plan. En effet, la synthèse 29 étant favorisée par une absorption de photons ayant une fréquence égale à une fréquence présente dans un des spectres électromagnétiques d'absorption et de diffusion inélastique de la matière à synthétiser, les générateurs de faisceaux de photons 11 sont agencés pour produire de telles photons.

Le dispositif est préférentiellement pourvu d'un générateur 12 de faisceaux de rayons UV-c. Les rayons UV-c peuvent être utilisés pour stimuler la réaction CH₄ → CH⁺₃ + H⁻ qui provoque ainsi une plus grande concentration de CH*₃ qui vont contribuer à la synthèse de la matière voulue.

Puisqu'un plasma doit être produit à l'intérieur de la chambre 2, le dispositif suivant l'invention comporte également une entrée reliée à une source d'alimentation 13 permettant d'introduire dans la chambre une substance porteuse de carbone, en particulier sous forme de gaz porteur de carbone, et de l'hydrogène (H₂). La substance qui est introduite est bien entendu en relation avec la matière à synthétiser. La source est reliée à la chambre par l'intermédiaire d'une vanne 14 de contrôle de débit agencée pour régler le débit du gaz injecté dans la chambre. Pour la formation de diamant la substance porteuse de carbone est introduite dans la chambre pour y produire un gaz comprenant des substances porteuses d'atomes de carbone réactif sous forme de radicaux ou de molécules insaturées à partir desquels la synthèse de la matière sera réalisée. Le gaz porteur de carbone est par exemple du méthane (CH₄) ou de l'acétylène (C₂H₂). Cette réaction de synthèse est connue en soi et est par exemple décrite dans l'article de «J.E. Butler, Y.A. Mankelevich, A. Cheesman, Jie Ma et M.N.R. Ashfold» intitulé «Understanding the chemical vapor déposition of diamond : recent progress» et paru dans Journal of Physics condensed Matter 21, 2009. Le cas échéant le gaz peut être préchauffé à l'aide d'un chauffage 15 avant de rentrer dans la chambre. Une unité de pompage 57 du gaz est reliée à la chambre pour pomper le gaz et permettre un équilibrage de la pression de gaz qui règne à l'intérieur de la chambre. Pour la formation d'une autre matière que le diamant, la substance nécessaire pour la formation de ladite matière est introduite dans la chambre pour y produire un gaz comprenant des substances porteuses d'atomes de base de la matière réactif sous forme de radicaux ou de molécules insaturées à partir desquels la synthèse de la matière sera réalisée.

Le dispositif 1 selon l'invention comporte le dispositif 32 générateur de photons agencé pour envoyer des photons 26 pompes sur le substrat 21. Le dispositif 32 générateur de photons comprend un ou plusieurs générateurs de photons 26 pompes, par exemple un ou plusieurs lasers aptes à émettre des photons 26 pompes de fréquence apte à placer une partie du substrat dans un état à partir duquel une émission Raman est possible. Le dispositif 32 générateur de photons comprend préférentiellement un ou plusieurs générateurs de photons pompes 26, par exemple un ou plusieurs lasers aptes à émettre des photons pompes 26 permettant, de par leur fréquence, une transition vers un état énergétique depuis lequel une émission Raman est possible. Le dispositif 32 générateur de photons est préférentiellement capable d'ajuster la polarisation des photons pompes 26.

Le dispositif 32 générateur de photons est potentiellement disposé dans de la chambre 2 ou dans une paroi de la chambre 2. Le dispositif 32 générateur de photons est potentiellement disposé en-dehors de la chambre 2, la chambre 2 ayant alors des parois agencées pour permettre le passage des photons 26 pompes.

Le dispositif 32 générateur de photons peut comprendre un laser à onde continue ou, de préférence, un laser pulsé, de façon à obtenir une très grande densité de photons 26 pompes. Si le dispositif 32 générateur de photons comprend un laser à onde continue, ce laser est préférentiellement de grande puissance et agencé pour émettre un faisceau de photons 26 pompes très focalisé. De plus, si le dispositif 32 générateur de photons 32 comprend un laser à onde continue, le dispositif 32 générateur de photons inclut aussi potentiellement une lentille agencée pour focaliser le faisceau de photons 26 pompes et des miroirs dichroïques sphériques afin de réaliser un balayage du faisceau de photons 26 pompes.

Le dispositif 1 selon l'invention peut comporter en outre, potentiellement, un dispositif 50 permettant un changement de direction des photons Raman 27, de façon à renvoyer les photons Raman 27 émis. Ce dispositif permettant un changement de direction des photons Raman 27 peut comporter une pluralité de miroirs. Le substrat 21 est alors préférentiellement disposé au centre d'une ou plusieurs cavité(s) résonante(s) comportant ces miroirs. En particulier, dans le cas de l'utilisation de photons Raman Stokes (figures 2a, 2b), les miroirs sont préférentiellement des miroirs dichroïques réfléchissant les photons Stokes et transparents pour les photons anti-Stokes et pour les photons 26 pompes.

La chambre 2 est agencée de façon à pouvoir y placer et en enlever le support 21. Par exemple, la chambre 2 peut comporter une porte 51 agencée pour donner accès au substrat 21 porté par le porte-substrat 3, notamment pour le mettre en place. Cette mise en place peut se faire en plaçant le substrat 21 sur le porte-substrat 3 préalablement installé dans la chambre 2 ou en plaçant en même temps dans la chambre le substrat 21 et le porte-substrat 3 ayant été préalablement positionnés ensemble. Dans le dispositif 1a prévu pour la première réalisation de l'invention, la porte 51 est agencée pour permettre de déposer le substrat 21 sur le porte-substrat 3 et d'enlever le substrat 21 du porte-substrat 3. Dans le dispositif 1b prévu pour la deuxième réalisation de l'invention, la porte 51 est agencée pour permettre de placer la tige 3 dans la chambre 2 et de sortir un tube de matière synthétisée 31 hors de la chambre 2.

Dans une réalisation de l'inventon, le substrat 21, les réactifs 25 et la zone de synthèse 29 se trouvent dans une ou plusieurs cavité(s) optique(s). Cette réalisation de l'invention peut par exemple est utilisée avec des photons Raman 27 Stokes. Dans une telle réalisation de l'invention, une première émission, en se référant aux figures 2a et 2b, un photon 26 pompe induit (figure 2a) une émission 24 Stokes spontanée qui crée un premier photon 27 Raman. Ce photon 27 Raman est redirigé 30 (figure 1) vers la zone où se produit la synthèse 29 où il induit une émission 28 Stokes stimulée. Dans une réalisation de l'invention où le substrat 21, les réactifs 25 et la zone de synthèse 29 se trouvent dans une ou plusieurs cavité(s) optique(s), le dispositif 50 permettant un changement de direction des photons Raman 27 fait partie des moyens pour diriger des photons Raman 27 dans la chambre.

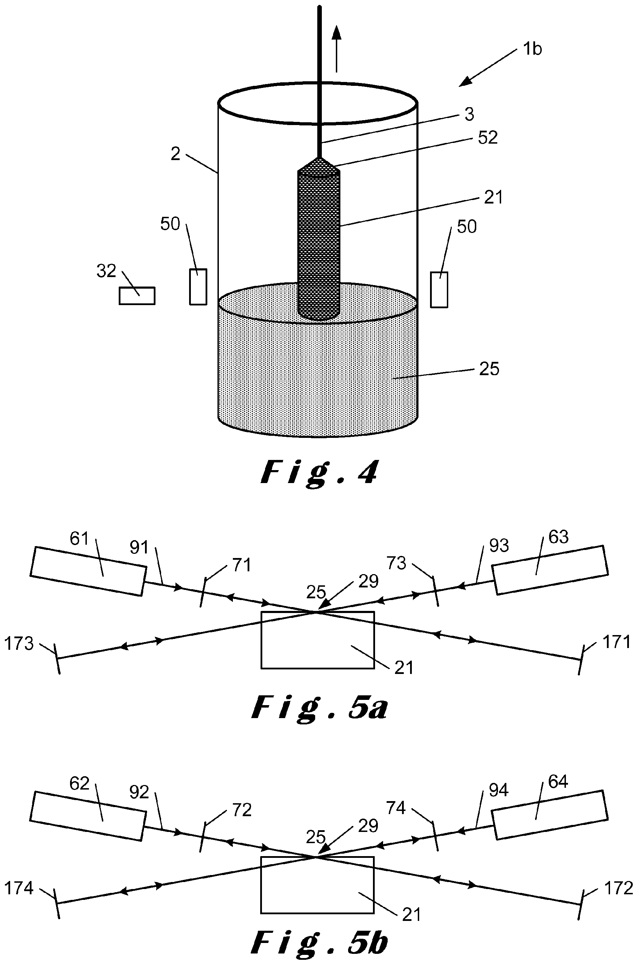

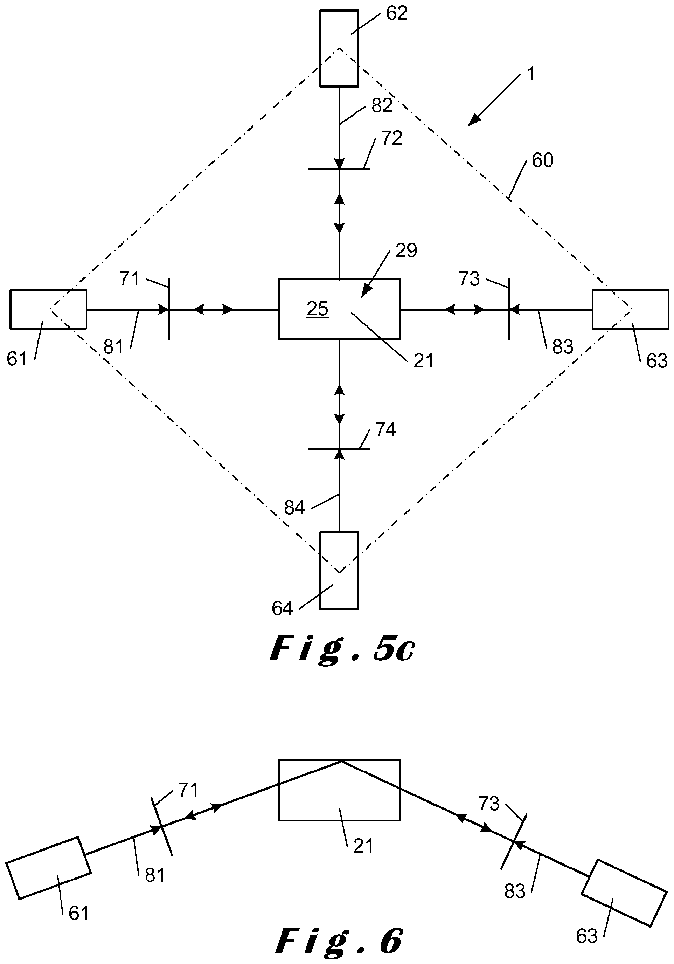

La figure 5 schématise une disposition de certains éléments du dispositif 1 dans une réalisation de l'invention où le substrat 21, les réactifs 25 et la zone de synthèse 29 se trouvent dans quatre cavités optiques. La figure 5a est une vue latérale dans une première direction, la figure 5b est une vue latérale dans une deuxième direction perpendiculaire à la première direction et la figure 5c est une vue du dessus.

La figure 5 montre une premier laser 61, un deuxième laser 62, un troisième laser 63 et un quatrième laser 64 qui font partie du dispositif 32 générateur de photons. La disposition illustrée, dans laquelle chaque laser est au coin d'un losange 60, est particulièrement appropriée dans le cas d'une synthèse par épitaxie d'un diamant monocristal de haute pureté et de qualité optique en réalisant une croissance [1,0,0] sur un parallélépipède dont les faces correspondent aux direction [1,1,0] et [1,0,1], le substrat 21 étant lui-même du diamant. La direction de polarisation des photons 26 pompes émis par les lasers 61-64 est choisie pour correspondre au gain Raman maximal du cristal de diamant.

La figure 5 montre aussi une premier miroir 71, un deuxième miroir 72, un troisième miroir 73, un quatrième miroir 74, un cinquième miroir 75, un sixième miroir 76, un septième miroir 77 et un huitième miroir 78 qui font partie du dispositif 50 permettant un changement de direction des photons Raman 27 émis. Le premier miroir 71 et le cinquième miroir 171 forment une première cavité optique. Le deuxième miroir 72 et le sixième miroir 172 forment une deuxième cavité optique. Le troisième miroir 73 et le septième miroir 173 forment une troisième cavité optique. Le quatrième miroir 74 et le huitième miroir 174 forment une quatrième cavité optique.

Les miroirs 71-74, 171-174 sont préférentiellement des miroirs dichroïques capables de réfléchir vers la zone de synthèse 29 des photons dont la fréquence est égale à celle des photons Raman 27 provenant de la zone de synthèse 29 et capables de laisser passer des photons 26 pompes provenant des lasers 61-64 et se dirigeant vers la zone de synthèse 29.

Le premier laser 61 émet un faisceau 81 de photons 26 pompes qui traverse le premier miroir 71 et arrive sur la zone de synthèse 29. Le deuxième laser 62 émet un faisceau 82 de photons 26 pompes qui traverse le deuxième miroir 72 et arrive sur la zone de synthèse 29. Le troisième laser 63 émet un faisceau 83 de photons 26 pompes qui traverse le troisième miroir 73 et arrive sur la zone de synthèse 29. Le quatrième laser 64 émet un faisceau 84 de photons 26 pompes qui traverse le quatrième miroir 74 et arrive sur la zone de synthèse 29.

Le fait que les miroirs dichroïques 71-74 soient agencés pour laisser passer les photons 26 pompes provenant d'un laser 61-64, avec le laser 61-64 disposé d'un premier côté du miroir dichroïque 71-74 la zone de synthèse 29 d'un deuxième côté du miroir dichroïque 71-74 permet que les photons 26 pompes provenant du laser 61-64 traversent les miroirs 71-74 alors que les photons 26 pompes et les photons Raman 27 provenant de la zone de synthèse 29 sont réfléchis par les miroirs 71-74 vers la zone de synthèse 29.

Les miroirs 71 et 171 sont disposés face à face sur un premier axe optique 91, perpendiculaires au premier axe optique 91, avec le substrat 21 entre eux. Les miroirs 72 et 172 sont disposés face à face sur un deuxième axe optique 92, perpendiculaires au deuxième axe optique 92, avec le substrat 21 entre eux. Les miroirs 73 et 173 sont disposés face à face sur un troisième axe optique 93, perpendiculaires au troisième axe optique 93, avec le substrat 21 entre eux. Les miroirs 74 et 174 sont disposés face à face sur un quatrième axe optique 94, perpendiculaires au quatrième axe optique 94, avec le substrat 21 entre eux.

L'émission Raman 28 engendre des photons Raman 27 qui peuvent aller se réfléchir dans les miroirs 71-74, ce qui correspond à l'étape 30 de changement de direction de la figure 1, pour revenir et provoquer des émissions Raman 28 stimulées.

Dans une réalisation de l'invention, le substrat 21, les réactifs 25 et la zone de synthèse 29 se trouvent dans une cavité résonante en anneau.

La figure 6 illustre une variante de l'invention utilisant le phénomène de réflexion totale. Dans cette variante de l'invention, la configuration latérale illustrée à la figure 6 remplace la configuration latérale illustrée à la figure 5a, et potentiellement la configuration latérale illustrée à la figure 5b, mais la configuration vue depuis le dessus illustrée à la figure 5c est toujours applicable. Un angle d'incidence des faisceaux de photons 26 pompes sur le substrat 21 est choisi pour que le faisceau subisse une réflexion totale sur une surface jouxtant le plasma d'ions 25 ou proche du plasma d'ions 25 dans la première réalisation de l'invention et jouxtant le liquide 25 ou proche du liquide 25 dans la deuxième réalisation de l'invention.

Dans une réalisation de l'invention, le substrat 21, les réactifs 25 et la zone de synthèse 29 se trouvent à l'extérieur d'un dispositif de génération de photons Raman qui peut comprendre une ou plusieurs cavité(s) optique(s).

La réalisation de l'invention dans laquelle le substrat 21, les réactifs 25 et la zone de synthèse 29 se trouvent à l'extérieur d'un dispositif de génération de photons Raman peut par exemple est utilisée avec des photons Raman 27 anti-Stokes. Dans une telle situation, des photons 26 pompes induisent des transitions Raman anti-Stokes dans le dispositif de génération de photons Raman qui génère des photons Raman 27 anti-Stokes qui sont ensuite envoyés vers la zone de synthèse 29, le substrat et les réactifs 25. Dans une réalisation de l'invention où le substrat 21, les réactifs 25 et la zone de synthèse 29 se trouvent à l'extérieur d'un dispositif de génération de photons Raman, le dispositif de génération de photons Raman fait partie des moyens pour diriger des photons Raman 27 dans la chambre.

Le dispositif de génération de photons Raman émet des photons Raman de "sonde" ou "de stimulation". Le dispositif de génération de photons Raman peut comprendre un ou plusieurs lasers. Le dispositif de génération de photons Raman est préférentiellement capable d'ajuster la polarisation des photons Raman. Le dispositif de génération de photons Raman est préférentiellement capable d'ajuster la fréquence des photons Raman. Le dispositif de génération de photons Raman est préférentiellement capable d'ajuster la phase des photons Raman.

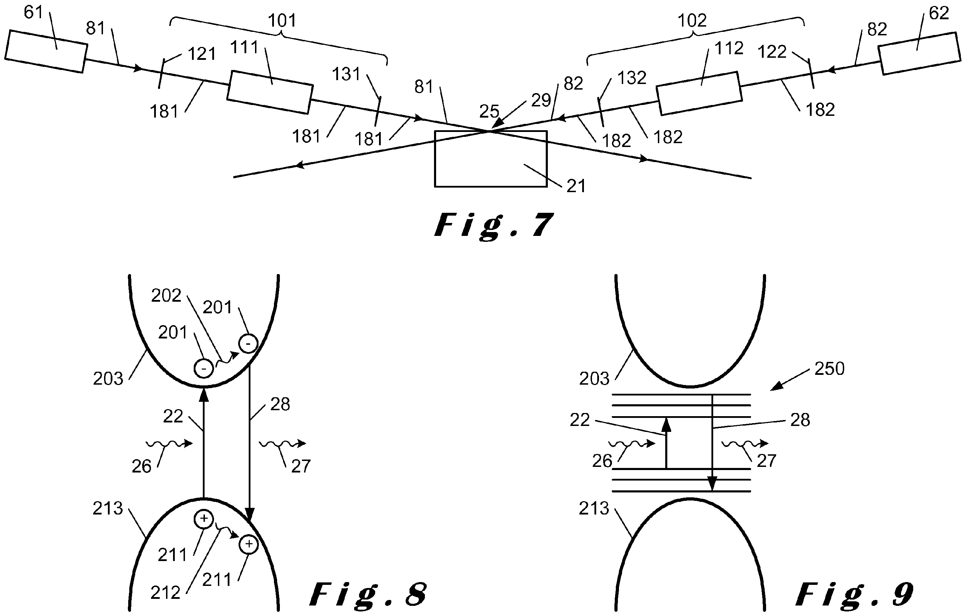

La figure 7 schématise une disposition de certains éléments du dispositif 1 dans une réalisation de l'invention où le substrat 21, les réactifs 25 et la zone de synthèse 29 se trouvent à l'extérieur d'un dispositif de génération de photons Raman qui comprend deux cavités optiques.

Un premier laser 61 envoie un premier faisceau 81 de photons 26 pompes qui passent dans une première cavité 101 optique extérieure. La première cavité 101 optique extérieure comprend deux miroirs dichroïques 121, 131 et un premier élément 111 apte à générer des photons Raman 27, par exemple un cristal de diamant de qualité optique. Les photons 26 induisent dans ce premier élément 111 apte à générer des photons Raman 27 des émissions Raman spontanées ou stimulées par des photons Raman 27 émis par cet élément et renvoyés grâce aux miroirs 121, 131. Ces émissions Raman génèrent des photons Raman 27 dans un faisceau Raman 181, dont une partie passe à travers le miroir 131 et arrivent à la zone de synthèse 29.

Un deuxième laser 62 envoie un deuxième faisceau 82 de photons 26 pompes qui passent dans une deuxième cavité 102 optique extérieure. La deuxième cavité 102 optique extérieure comprend deux miroirs dichroïques 122, 132 et un deuxième élément 112 apte à générer des photons Raman 27, par exemple un cristal de diamant de qualité optique. Les photons 26 induisent dans ce deuxième élément 112 apte à générer des photons Raman 27 des émissions Raman spontanées ou stimulées par des photons Raman 27 émis par cet élément et renvoyés grâce aux miroirs 122, 132. Ces émissions Raman génèrent des photons Raman 27 dans un faisceau Raman 182, dont une partie passe à travers le miroir 132 et arrivent à la zone de synthèse 29.

Ainsi, les photons 26 pompes et les photons Raman 27 sont présents lors de la synthèse 29 de matière 31, ce qui permet de réunir les conditions pour un effet Raman dans la matière.

Il est possible que plus de lasers et/ou de cavités optiques extérieures soient employées, par exemple quatre lasers et quatre cavités optique.

La figure 8 schématise une première utilisation d'une émission anti-Stokes pour réaliser un pompage de phonons. Une paire électron 201-trou 211 est créée grâce au photon pompe 26. L'électron 201 se trouve dans la bande de conduction 203 et le trou 211 dans la bande de valence 213. Le pompage de deux phonons 202, 212 permet que l'énergie du photon Raman 27 émit lors de l'annihilation de la paire électron 201-trou 211 soit plus grande que l'énergie du photon pompe 26.

La figure 9 schématisé une deuxième utilisation une émission anti-Stokes pour réaliser un pompage de phonons. Cette utilisation suppose qu'une impureté, par exemple un centre coloré dans un diamant, crée des états 250 d'énergie intermédiaires entre la bande de valence 213 et la bande de conduction 203. Le photon pompe 26 induit une excitation entre deux de ces états d'énergie intermédiaires. L'émission Raman anti-Stokes induit une désexcitation entre deux de ces états d'énergie intermédiaires. Le pompage de deux phonons permet que l'énergie du photon Raman 27 émit soit plus grande que l'énergie du photon pompe 26.

Dans une réalisation de l'invention, la fréquence des photons 26 pompes et/ des photons Raman 27 est choisie pour briser spécifiquement certaines liaisons chimiques. Ainsi, notamment, des liaisons chimiques correspondant à une structure amorphe peuvent être brisées et remplacées par des liaisons chimiques correspondant à une structure cristalline. Par exemple, dans le cas de la synthèse du diamant, des liaisons sp2 qui ne correspondent pas à une structure cristalline peuvent être déstabilisées en excitant la transition de π vers π* par des photons à 193 nm de longueur d'onde. Cela peut se faire de façon simultanée avec la synthèse 29 ou après la synthèse 29.

Dans une réalisation de l'invention, les photons 26 pompes et/ou les photons Raman 27 sont envoyés de façon rasante par rapport à une surface du substrat 21 sur laquelle croît la matière 31.

En d'autres termes, l'invention se rapporte à une méthode et un dispositif pour synthétiser une matière 31. La méthode implique un substrat 21 à proximité duquel sont fournis des réactifs 25. Des photons pompes 26 et des photons Raman 27 permettent de créer une émission Raman stimulée lors de la synthèse 29 de la matière. L'émission Raman peut être Stokes ou anti-Stokes. Dans une réalisation de l'invention, la zone où la synthèse 29 se produit est dans une cavité optique et des photons Raman 27 émis par l'émission Raman sont redirigés vers la zone où la synthèse 29 se produit. Dans une autre réalisation de l'invention, la zone où la synthèse 29 se produit n'est pas dans une cavité optique, et un flux de photons Raman 27 est créé dans une cavité optique extérieure avant d'être envoyé vers la zone où la synthèse 29 se produit.

## Revendications

1. Méthode de synthèse d'une matière (31), la méthode comprenant les étapes de :
1) on fournit une chambre (2),
2) on place dans la chambre (2) un substrat (21) agencé pour supporter la matière (31) à synthétiser,
3) on fournit un dispositif (32) générateur de photons agencé pour envoyer des photons pompes (26) dans la chambre (2),
4) on fournit dans la chambre (2), à proximité du substrat, des réactifs (25) pour synthétiser ladite matière (31) comprenant un gaz, et on ionise au moins une partie dudit gaz de façon à former un plasma comprenant des ions à proximité du substrat,
5) on fournit des moyens pour diriger des photons Raman (27) dans la chambre (2),
6) on envoie dans la chambre (2) sur une surface du substrat (21) proche des réactifs des photons pompes (26) de fréquence apte à placer une partie du substrat dans un état à partir duquel une émission Raman est possible,
7) la surface du substrat proche des réactifs émet un photon Raman, et
8) on redirige les photons Raman (27) émis par le substrat (21) vers les réactifs à proximité du substrat (21) pour synthétiser la matière (31) sur le substrat (21) à partir des réactifs (25)

2. Méthode selon la revendication 1, dans laquelle les moyens pour diriger des photons Raman (27) dans la chambre (2) comprennent un dispositif (50) permettant un changement de direction de photons Raman (27) et l'étape 8) comprend un changement de direction de photons Raman (27) à l'aide d'une cavité optique.

3. Méthode selon la revendication 1, dans laquelle les moyens pour diriger des photons Raman (27) dans la chambre (2) comprennent un dispositif de génération de photons Raman (27).

4. Méthode selon la revendication 3, dans laquelle le dispositif de génération de photons Raman est comprend une cavité optique (101, 102) et un élément (111, 112) apte à générer des photons Raman (27) et le substrat (21) est disposé en- dehors du dispositif de génération de photons Raman.

5. Méthode selon l'une quelconque des revendications précédentes, dans laquelle les étapes 6), 7) et 8) sont simultanées.

6. Méthode selon l'une quelconque des revendications précédentes comprenant en outre une étape de réflexion totale des photons (26) pompes sur une surface proche des réactifs (25).

7. Méthode selon l'une quelconque des revendications précédentes, dans laquelle la matière (31) à synthétiser est une matière solide, une matière solide monocristalline, une matière solide poly-cristalline, une matière solide amorphe, une matière solide synthétisable par CVD, une matière solide ayant une structure cristalline de type diamant, une matière solide de même composition que du diamant mais étant au moins partiellement amorphe ou un diamant.

8. Dispositif (1) pour synthétiser une matière (31), le dispositif (1) comprenant :
• une chambre (2) comprenant :
o un porte-substrat (3) agencé de façon à porter un substrat (21),
o une porte (51) agencée pour placer un substrat (21) sur le porte-substrat (3),
• un dispositif (32) générateur de photons agencé de façon à envoyer des photons pompes (26) dans la chambre (2) vers le substrat,
• une entrée agencée pour permettre de fournir dans la chambre (2) des réactifs (25), et
• des moyens pour diriger des photons Raman (27) dans la chambre (2), vers le substrat (21), dispositif dans lequel la chambre est agencée pour pouvoir être mise sous vide et pouvoir contenir un plasma d'ions (25) et comprenant en outre un dispositif de création de plasma apte à ioniser au moins une partie un gaz pour former un plasma à proximité d'un substrat (21) porté par un porte-substrat.

9. Dispositif (1) selon la revendication 8, dans lequel les moyens pour diriger des photons Raman (27) dans la chambre comprennent un dispositif (50) permettant un changement de direction de photons Raman (27) et apte à diriger des photons Raman (27) vers le substrat (21).

10. Dispositif (1) selon la revendication 19, dans lequel le dispositif (50) agencé pour réaliser un changement de direction de photons Raman (27) comprend deux miroirs (71, 73) disposés pour réfléchir vers un substrat (21) porté par le porte- substrat (3) des photons Raman (27) provenant du substrat (21) porté par le porte-substrat (3).

11. Dispositif (1) selon la revendication 10, dans lequel au moins un des miroirs (71, 73) est un miroir dichroïque agencé pour laisser passer les photons (26) pompes provenant du dispositif (32) générateur de photons.

12. Dispositif (1) selon l'une quelconque des revendications 9 à 11, dans lequel le dispositif (50) agencé pour réaliser un changement de direction de photons Raman (27) comprend une cavité optique.

13. Dispositif (1) selon l'une quelconque des revendications 9 à 12, dans lequel la chambre (2) est agencée pour pouvoir contenir un liquide (25), dans lequel le porte-substrat (3) est un élément allongé agencé pour pouvoir tirer un substrat (21) dans un mouvement d'éloignement du liquide (25) et comprenant en outre une entrée agencée pour introduire un liquide (25) dans la chambre (2).

## Patentansprüche

1. Syntheseverfahren eines Materials (31), wobei das Verfahren die Schritte umfasst:
1) Es wird eine Kammer (2) geliefert,
2) In die Kammer (2) wird ein Substrat (21) platziert, das angeordnet ist, um das zu synthetisierende Material (31) zu stützen,
3) Es wird eine Photonenerzeuger-Vorrichtung (32) geliefert, die angeordnet ist, um Pumpenphotone (26) in die Kammer (2) zu schicken,
4) In der Kammer (2) werden in der Nähe des Substrats Reagenzien (25) zum Synthetisieren des genannten Materials (31), umfassend ein Gas, geliefert, und es wird wenigstens ein Teil des genannten Gases derart ionisiert, dass ein Plasma gebildet wird, das Ionen in der Nähe des Substrats umfasst,
5) Es werden Mittel geliefert, um Ramanphotonen (27) in die Kammer (2) zu leiten,
6) Auf einer Oberfläche des Substrats (21) nahe den Reagenzien werden Pumpenphotonen (26) mit einer Frequenz, die geeignet ist, einen Teil des Substrats in einen Zustand zu versetzen, ab dem eine Ramanemission möglich ist, in die Kammer (2) geschickt,
7) Die Oberfläche des Substrats nahe den Reagenzien sendet ein Ramanphoton und
8) Die von dem Substrat (21) ausgegebenen Ramanphotonen (27) werden zu den Reagenzien in der Nähe des Substrats (21) zum Synthetisieren des Materials (31) auf dem Substrat (21) ausgehend von Reagenzienz (25) umgeleitet.

2. Verfahren gemäß Anspruch 1, bei dem die Mittel zum Leiten der Ramanphotonen (27) in die Kammer (2) eine Vorrichtung (50) umfassen, die eine Richtungsänderung von Ramanphotonen (21) zulässt, und der Schritt 8) umfasst eine Richtungsänderung von Ramanphotonen (27) mithilfe eines optischen Resonators.

3. Verfahren gemäß Anspruch 1, bei dem die Mittel zum Leiten der Ramanphotonen (27) in die Kammer (2) eine Erzeugungsvorrichtung von Ramanphotonen (27) umfassen.

4. Verfahren gemäß Anspruch 3, bei dem die Erzeugungsvorrichtung von Ramanphotonen einen optischen Resonator (101, 102) und ein Element (111, 112) umfasst, das geeignet ist, um Ramanphotonen (27) zu erzeugen, und das Substrat (21) außerhalb der Erzeugungsvorrichtung von Ramanphotonen angeordnet ist.

5. Verfahren gemäß irgendeinem der voranstehenden Ansprüche, bei dem die Schritte 6), 7) und 8) gleichzeitig erfolgen.

6. Verfahren gemäß irgendeinem der voranstehenden Ansprüche, umfassend darüber hinaus einen totalen Reflektionsschritt der Pumpenphotonen (26) auf einer Oberfläche nahe den Reagenzien (25) .

7. Verfahren gemäß irgendeinem der voranstehenden Ansprüche, bei dem das zu synthetisierende Material (31) ein festes Material, ein monokristallines festes Material, ein polykristallines festes Material, ein amorphes festes Material, ein per CVD synthetisierbares festes Material, ein festes Material mit einer kristallinen Struktur vom Typ Diamant, ein festes Material mit derselben Zusammensetzung wie ein Diamant ist, jedoch wenigstens teilweise amorph oder ein Diamant ist.

8. Vorrichtung (1) zum Synthetisieren eines Materials (31), wobei die Vorrichtung (1) umfasst:
• eine Kammer (2), umfassend:
o einen Substratträger (3), der derart angeordnet ist, dass ein Substrat (21) getragen ist,
o eine Tür (51), die angeordnet ist, um ein Substrat (21) auf dem Substratträger (3) zu platzieren,
• eine Photonen-Erzeugervorrichtung (32), die derart angeordnet ist, dass Pumpenphotonen (26) in die Kammer (2) zu dem Substrat geschickt werden,
• einen Eingang, der angeordnet ist, um das Liefern der Reagenzien (25) in die Kammer (2) zuzulassen, und
• Mittel zum Leiten der Ramanphotonen (27) in die Kammer (2) zum Substrat (21),
Vorrichtung, in der die Kammer angeordnet ist, um vakuumiert werden und ein Ionenplasma (25) enthalten zu können und umfassend darüber hinaus eine Plasma-Erzeugungsvorrichtung, die geeignet ist, wenigstens einen Teil eines Gases zu ionisieren, um ein Plasma in der Nähe eines Substrats (21) zu bilden, das von einem Substratträger getragen ist.

9. Vorrichtung (1) gemäß Anspruch 8, bei dem die Mittel zum Leiten der Ramanphotonen (27) in die Kammer eine Vorrichtung (50) umfassen, die eine Richtungsänderung von Ramanphotonen (27) zulässt und geeignet ist, um Ramanphotonen (27) zum Substrat (21) zu leiten.

10. Vorrichtung (1) gemäß Anspruch 19, bei der die Vorrichtung (50), die angeordnet ist, um eine Richtungsänderung von Ramanphotonen (27) zu realisieren, zwei Spiegel (71, 73) umfasst, die angeordnet sind, um zu einem Substrat (21) zu reflektieren, das vom Substratträger (3) der Ramanphotonen (27) getragen ist, die vom Substrat (21) stammen, das vom Substratträger (3) getragen ist.

11. Vorrichtung (1) gemäß Anspruch 10, bei der wenigstens einer der Spiegel (71, 73) ein dichroitischer Spiegel ist, der angeordnet ist, um die Pumpenphotonen (26), die von der Photonen-Erzeugungsvorrichtung (32) stammen, hindurchtreten zu lassen.

12. Vorrichtung (1) gemäß irgendeinem der Ansprüche 9 bis 11, bei der die Vorrichtung (50), die angeordnet ist, um eine Richtungsänderung von Ramanphotonen (27) zu realisieren, einen optischen Resonator umfasst.

13. Vorrichtung (1) gemäß irgendeinem der Ansprüche 9 bis 12, bei der die Kammer (2) angeordnet ist, um eine Flüssigkeit (25) enthalten zu können, bei der der Substratträger (3) ein längliches Element ist, das angeordnet ist, um ein Substrat (21) in eine Verlängerungsbewegung der Flüssigkeit (25) zu ziehen, und umfassend darüber hinaus einen Eingang, der zum Einführen einer Flüssigkeit (25) in die Kammer (2) angeordnet ist.

## Claims

1. A method for synthesizing a material (31), the method comprising the following steps:
1) providing a chamber (2),
2) placing a substrate (21) arranged to bear the material (31) to be synthesized in the chamber (2),
3) providing a photon-generating device (32) arranged to send pump photons (26) into the chamber (2),
4) providing in the chamber (2), near the substrate, reagents (25) to synthesize said material (31) comprising a gas, and ionising at least part of said gas in order to form a plasma comprising ions close to the substrate,
5) providing means for steering Raman photons (27) in the chamber (2),
6) sending, in the chamber (2) on a surface of the substrate (21) close to the reagents, pump photons (26) at a frequency likely to transform a part of the substrate into a state from which Raman emission is possible,
7) the surface of the substrate close to the reagents emits a Raman photon, and
8) steering Raman photons (27) emitted by the substrate (21) toward the reagents close to the substrate (21) to synthesize the material (31) on the substrate (21) from the reagents (25).

2. The method according to claim 1, wherein the means for steering Raman photons (27) in the chamber (2) comprise a device (50) allowing a change of direction of Raman photons (27) and step 8) comprises a change of direction of Raman photons (27) using an optical cavity.

3. The method according to claim 1, wherein the means for steering Raman photons (27) in the chamber (2) comprise a device for generating Raman photons (27).

4. The method according to claim 3, wherein the device for generating Raman photons comprises an optical cavity (101, 102) and an element (111, 112) capable of generating Raman photons (27), and the substrate (21) is arranged outside the device for generating Raman photons.

5. The method according to any of the above claims, wherein steps 6), 7) and 8) are simultaneous.

6. The method according to any of the above claims, further comprising a step for total reflection of the pump photons (26) on a surface close to the reagents (25).

7. The method according to any of the above claims, wherein the material (31) to be synthesized is a solid material, a monocrystalline solid material, a polycrystalline solid material, an amorphous solid material, a solid material able to be synthesized by CVD, a solid material having a diamond-type crystalline structure, a solid material with the same composition as diamond but being at least partially amorphous or a diamond.

8. A device (1) for synthesizing a material (31), the device (1) comprising:
• a chamber (2) comprising:
o a substrate holder (3) arranged so as to hold a substrate (21),
o a door (51) arranged to place a substrate (21) on the substrate holder (3),
• a photon-generating device (32) arranged so as to send pump photons (26) into the chamber (2) towards the substrate,
• an inlet arranged to make it possible to provide reagents (25) in the chamber (2), and
• means for steering Raman photons (27) in the chamber (2), towards the substrate (21),
a device in which the chamber is arranged so that it can be placed under vacuum and is able to contain an ion plasma (25) and further comprising a plasma creating device capable of ionising at least part of a gas to provide a plasma near the substrate (21) held by a substrate holder.

9. The device (1) according to claim 8, wherein the means for steering Raman photons (27) in the chamber comprise a device (50) allowing a change of direction of Raman photons (27) and capable of steering Raman photons (27) toward the substrate (21).

10. The device (1) according to claim 9, wherein the device (50) arranged to carry out a change of direction of Raman photons (27) comprises two mirrors (71, 73) arranged to reflect, toward a substrate (21) held by the substrate holder (3), Raman photons (27) coming from the substrate (21) held by the substrate holder (3) .

11. The device (1) according to claim 10, wherein at least one of the mirrors (71, 73) is a dichroic mirror arranged to allow the pump photons (26) coming from the photon-generating device (32) to pass.

12. The device (1) according to any of claims 9 to 11, wherein the device (50) arranged to carry out a change of direction of Raman photons (27) comprises an optical cavity.

13. The device (1) according to any of claims 9 to 12, wherein the chamber (2) is arranged to be able to contain a liquid (25), in which the substrate holder (3) is an elongate element arranged to be able to pull a substrate (21) into a movement separating it from the liquid (25) and further comprising an inlet arranged to introduce a liquid (25) into the chamber (2).
